(19) Europäisches Patentamt
European Patent Office
Office européen des brevets

(11) EP 0 386 518 B1

(12) **EUROPEAN PATENT SPECIFICATION**

(45) Date of publication and mention
of the grant of the patent:
**09.06.1999 Bulletin 1999/23**

(51) Int Cl.[6]: **H01L 21/465**

(21) Application number: **90103252.4**

(22) Date of filing: **20.02.1990**

(54) **Etching method for compound semiconductors**

Ätzverfahren für Verbindungshalbleiter

Procédé d'attaque pour semi-conducteurs composés

(84) Designated Contracting States:
**DE FR GB**

(30) Priority: 23.02.1989 JP 4347689
07.04.1989 JP 8898289
07.04.1989 JP 8898389
07.04.1989 JP 8898489
10.04.1989 JP 9030889
15.05.1989 JP 12071389
15.05.1989 JP 12071489
15.05.1989 JP 12071589
15.05.1989 JP 12071689
15.05.1989 JP 12071789
15.05.1989 JP 12071889
12.05.1989 JP 11972089
12.05.1989 JP 11972189
12.05.1989 JP 11972889
12.05.1989 JP 11973289
30.05.1989 JP 13680189
30.05.1989 JP 13680289
04.07.1989 JP 17234089
31.10.1989 JP 28353189

(43) Date of publication of application:
**12.09.1990 Bulletin 1990/37**

(73) Proprietor: **SEIKO EPSON CORPORATION**
**Shinjuku-ku Tokyo-to (JP)**

(72) Inventors:
• **Iwano, Hideaki, c/o Seiko Epson Corporation**
**Suwa-shi, Nagano-Ken (JP)**
• **Asaga, Tatsuya, c/o Seiko Epson Corporation**
**Suwa-shi, Nagano-Ken (JP)**
• **Seki, Tetsuya, c/o Seiko Epson Corporation**
**Suwa-shi, Nagano-Ken (JP)**

(74) Representative:
**Hoffmann, Eckart, Dipl.-Ing. et al**
**Patentanwalt,**
**Bahnhofstrasse 103**
**82166 Gräfelfing (DE)**

(56) References cited:
**EP-A- 0 191 143** **US-A- 4 734 152**

• **JOURNAL OF VACUUM SCIENCE &**
**TECHNOLOGY B, vol. 7, no. 1, January-February**
**1989, pages 59-67, American Vacuum Society; J.**
**PELLETIER et al.: "Microwave plasma etching of**
**Si and SiO2 in halogen mixtures: interpretation**
**of etching mechanisms"**
• **APPLIED PHYSICS LETTERS, vol. 53, no. 8, 22nd**
**August 1988, pages 690-691, American Institute**
**of Physics, New York, US; E.M. CLAUSEN et al.:**
**"Etching and cathodoluminescence studies of**
**ZnSe"**
• **"VSLI Technology", (second edition), S.M. Sze,**
**McCraw-Hill, 1988, pp. 184-232**

## Description

This invention relates to etching methods of Zn $S_x$ $Se_{1-x}$ ($0 \leq x \leq 1$) compound semiconductors.

Micro processing techniques of the prior art for processing II-VI group compound semiconductors comprised of zinc selenide (ZnSe), zinc sulfide (ZnS), or a mixture of ZnSe and ZnS are wet etching and dry etching wherein an insulation film, such as photoresist, silicon dioxide, or the like, is used as a mask. In wet etching, the etching solutions mainly are a solution of sodium hydroxide, hydrochloric acid, and a compound solution of nitric acid, hydrochloric acid, and water. These etching solutions are used at appropriate temperatures and composition to achieve a desired etching speed.

Dry etching techniques include ion etching by inactive gas, such as, Ar or the like, wherein capacitively coupled parallel-electrode means is employed, and reactive ion etching by reactive gas, such as $BCl_3$. The document "Applied Physics Letters", Vol. 53, No. 8, 22nd August 1988, American Institute of Physics, New York, pp. 690, 691, discloses such technique for etching ZnSe grown on semi-insulating GaAs substrates. In this prior art the etching was carried out in a parallelplate electrode etching system in which mixtures of $BCl_3$ and Ar were used for the plasma gas. The optimum etching conditions were found to be 100% $BCl_3$ at 1.13 W/cm$^2$ and 0.133 Pa.

However, there are problems in these techniques of the prior art for processing II-VI group compound semiconductors as described below.

In connection with wet etching, a common problem is that it lacks in reproducibility. A fixed etching speed cannot be achieved unless the temperature and the composition of the etching solution are controlled very closely. Also, in the case of an etching solution which contains a volatile material, the composition of the solution changes greatly as time goes by. Therefore, etching speed at the time when the solution was made and etching speed after a while differ dramatically. Further, in wet etching technique, the pattern cannot be formed to be the same as the mask because etching progresses equally to all directions, thereby causing side etching. Also, the patterns of processed sections are limited, for example, formation of perpendicular sections or deep grooves with large length/breadth ratio is difficult.

Wet etching of II-VI group compound semiconductors has more problems than wet etching of other semiconductors, such as III-V group compound semiconductors. For example, where etching of ZnSe is performed in a hydrochloric acid and nitric acid etching solution, the etching solution penetrates into ZnSe, and it is very difficult to remove it completely even by rinsing for a long time, thereby substantially worsening the film characteristics. Also, in the case of etching ZnSe, $ZnS_x$ $Se_{1-x}$ ($0 < x \leq 1$) in a solution of NaOH, the surface morphology worsens extremely, therefore, it is not suitable for precision etching. In the case when hydrochloric acid is employed, the etching speed is very slow, therefore, it is not practical for manufacturing devices employing II-VI group compound semiconductors.

On the other hand, with ion etching employing inactive gas, such as Ar, in order to bring up the etching speed to a practical level, it is necessary to raise up plasma discharge power, thereby causing substantial damage to a semiconductor substrate. Also, in the case of reactive ion etching employing reactive gas, such as $BCl_3$, damage to the substrate is less to a certain degree compared to ion etching, however, it is still not in the permissible range. In order to simply lessen damage, gas pressure can be raised while discharge power is low. Then, however, the ion sheath width and the mean free path of ions and neutral particles become almost the same, causing the ion beam to lose directionality, thereby causing more side etching. Thus, reactive ion etching has a substantial drawback from the view point of micro processing.

Etching of II-VI group compound semiconductors by means of the prior art is very difficult as mentioned above, and it has been a big obstacle in manufacturing devices employing II-VI group compound semiconductors.

The document "VLSI Technology", (Second Edition), S. M. Sze, McGraw-Hill, 1988, pp. 184-232 discloses a Reactive Ion Beam (RIBE) Etcher using an Electron Cyclotron Resonance (ECR) chamber as an ion source. According to this document a RIBE arrangement is advantageous because the energy and the density of ions can be separately controlled since the reactive ions are generated in one section of the chamber and then accelerated through one or more grids toward the wafer surface. The same type of reactive gases as in reactive plasma processes can be used. Radiation damage because of high; energy ions is said to present a problem in some cases. A microwave discharge using ECR to produce a dense plasma is disclosed to eliminate a problem involved in RIBE arrangements using hot cathodes to emit electrons.

This invention is to solve the foregoing problems, and the objective is to manufacture devices employing Zn $S_x$ $Se_{1-x}$ ($0 \leq x \leq 1$) compound semiconductors with excellent reproducibility by providing etching methods of Zn $S_x$ $Se_{1-x}$ ($0 \leq x \leq 1$) compound semiconductors with reproducibility, practicality, extremely small damage to substrates after etching, and capability of forming various processed patterns.

This object is achieved with a method as claimed in claim 1.

Specific embodiments of the invention are characterized in the dependent claims.

Embodiments of the invention will be described in detail hereinafter with reference to the drawings, wherein:

Fig. 1(a), (b)        show cross sectional views of a

masked substate to illustrate one embodiment of this invention wherein etching of ZnSe is performed employing a photoresist as an etching mask,

Fig. 2(a), (b)    show the photo luminescence of ZnSe layers before and after etching according to this invention,

Fig. 3    shows the relationship of etching speed and gas pressure in one example which does not entirely full within the claimed invention,

Fig. 4    shows the relationship of etching speed and microwave inlet-power in one embodiment of this invention,

Fig. 5    shows the relationship of etching speed and acceleration voltage in one embodiment of this invention,

Fig. 6(a) to (e)    show cross sectional views of a sample to illustrate another embodiment of this invention wherein perpendicular edge surface etching of ZnSe was performed,

Fig. 7(a), (b)    show cross sectional views of a sample to illustrate an embodiment of this invention wherein diagonal groove etching of ZnSe was performed,

Fig. 8    shows a structural drawing of an etching system employed in one embodiment of this invention,

Fig. 9(a) to (c)    illustrate a manufacturing process of an etching mask in one embodiment of this invention,

Fig. 10(a), (b)    show a sample processed according to one embodiment wherein etching of ZnSe was performed according to this invention,

Fig. 11    shows a structural drawing of an etching system employed in one embodiment of this invention,

Fig. 12(a) to (c)    show cross sectional views of a sample processed according to a comparative example which does not full within the scope of the invention, wherein etching of ZnSe was performed,

Fig. 13    shows a structural drawing of an etching system employed in one embodiment of this invention,

Fig. 14    shows a structural drawing of an etching system employed in one embodiment of this invention,

Fig. 15(a), (b)    show cross sectional views of a sample wherein etching of ZnSe was performed,

Fig. 16    shows the relationship of substrate temperature and etching rate,

Fig. 17    shows a structural drawing of an etching system employed in one embodiment of this invention,

Fig. 18(a), (b)    show cross sectional views of a sample wherein etching of ZnSe on GaAs was performed according to this invention, and

Fig. 19    shows a structural drawing of an etching system employed in one embodiment of this invention.

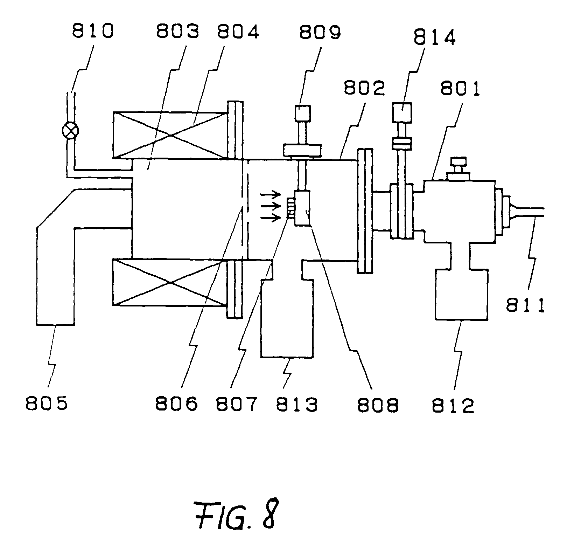

Fig. 8 shows a cross sectional view of the structural outline of one embodiment of an etching system which may be employed in this invention. Since a gas including a halogenous element, which has strong reactivity, is employed as etching gas, a sample preparation chamber 801 and an etching chamber 802 are separated by a gate valve 814, and etching chamber 802 is always kept in high vacuum condition. An electron-cyclotron resonance (ECR) plasma chamber 803 is surrounded by a cylindrical magnetic coil 804, and there is a quartz plate window for microwave inlet at the contacting part with a microwave waveguide 805. Electrons which are generated by microwave, repeat colliding with gas molecules while performing cyclotron movement caused by a symmetric magnetic field. When the intensity of the magnetic field is, for example, 875 G, the revolution cycle matches with the microwave frequency, for example, 2.45 GHz, and the electron system absorbs microwave energy resonantly. Therefore, discharge continues even when the gas pressure is low, thereby rendering high plasma density and, thus, long life use of the reactive gas. Also, since electrons and ions gather toward the center because of the electric field distribution, sputtering effect by ions on the side wall of the plasma chamber is minimal, thereby providing plasma with high purity. Ions generated in plasma chamber 803 are accelerated by a mesh acceleration electrode 806 and irradiated to a sample 807. Sample holder 808 can be rotated 360° about a vertical axis by a manipulator 809, thereby enabling to change the direction of ion beam inlet to the sample. In Fig. 8 810 designates a gas inlet, 811 a transporting shaft, 812 and 813 evacuating systems.

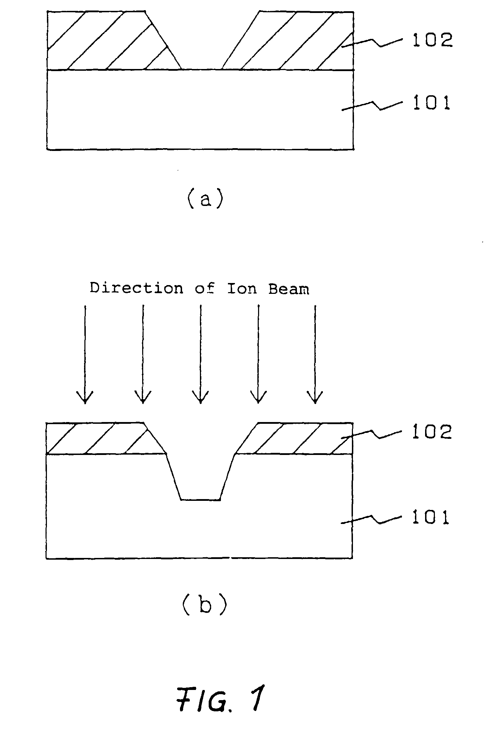

Fig. 1 shows a cross sectional view of a sample which was processed according to one embodiment of the invention employing the system in Fig. 8.

Fig. 1(a) shows a cross sectional view before etching. 101 is ZnSe, 102 is an etching mask. A posi-type photoresist is employed as etching mask 102. Since the mask was manufactured by regular photolithography, the cross sectional pattern of the mask was taper. Etching was performed under the condition wherein 99.999% pure chlorine was employed as reactive gas, the gas pressure was $1.0 \times 10^{-1}$ Pa, the microwave inlet-power was 100W, the acceleration voltage was 500V, the sample temperature was 25°C, and the ion beam irradiation direction was perpendicular relative to the substrate. Fig. 1(b) shows a cross sectional view after etching. The etching speed of ZnSe was approximately 60 nm/min (600 Å/min), on the other hand, the etching speed of a posi-type photoresist is, when the condition of post bake is at 120°C for 30 minutes, approximately 20 nm/min (200 Å/min). Since the pattern of the etching mask had a taper shape, and sputtering causes slight etching on the etching mask, the cross sectional pattern of the processed sample was as shown in Fig. 1(b). Even with the ion beam being irradiated perpendicularly, perpendicular side walls in cross section could not be obtained. However, as far as the etching speed is concerned, there is no problem for a practical use. Further, the dispersion of the etching speed on the material when the substrate was 20mm x 20mm was $\leq\pm5\%$, and the surface morphology was almost the same as before the process.

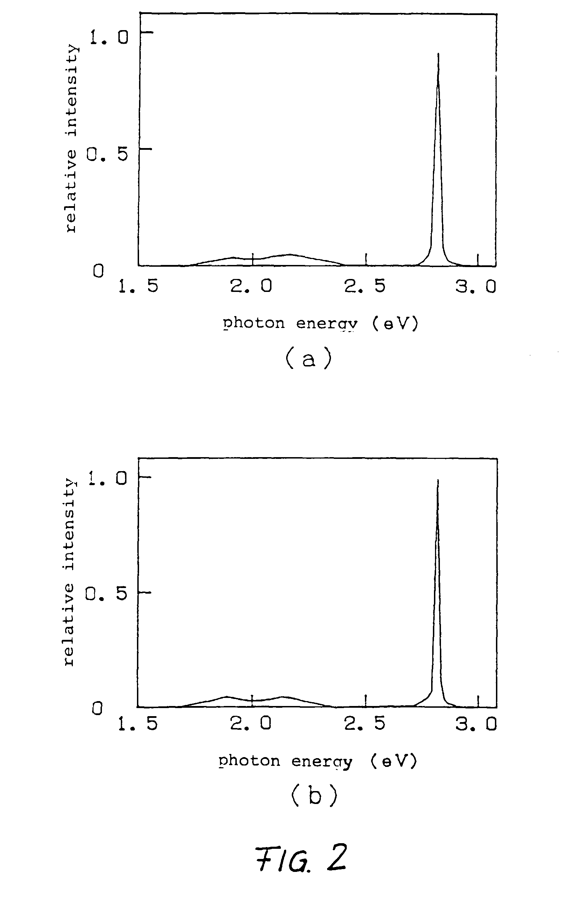

Fig. 2(a) and Fig. 2(b) show a comparison of the photo luminescence of the ZnSe substrate before and after the etching under the foregoing condition. Fig. 2(a) is before and Fig. 2(b) is after etching. Since the ratio between the luminescence relative intensity from a band edge and that from a deep level is about 50 before and after etching, it is clear that there is practically no damage to semiconductor layers.

The effective etching condition for practical use, such as for manufacturing devices, is described hereinafter.

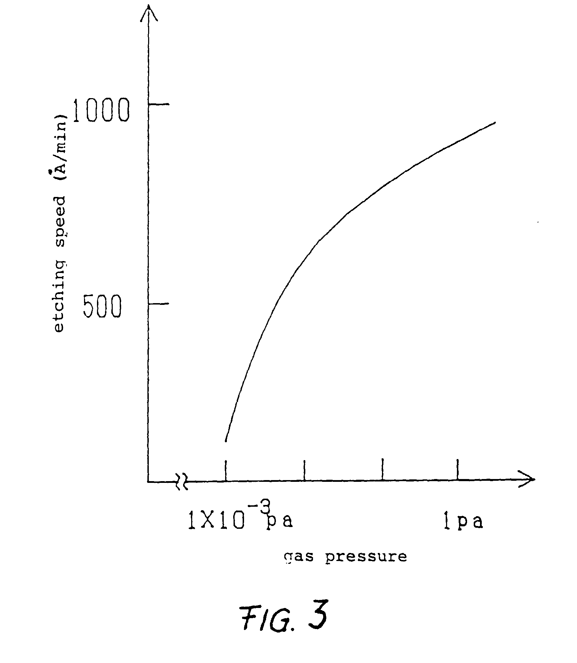

First, as shown in Fig. 3, qualitatively speaking, the etching speed increases as the gas pressure increases. However, when the gas pressure is too high, discharge does not occur. Even when discharge occurs ($\geq$1 Pa), the ion sheath width and the mean free path of ions and neutral particles become almost the same, thereby causing the ion beam to lose its directionality. Therefore, this is not suitable for micro processing. When the gas pressure is too low [$\leq$($1 \times 10^{-3}$)Pa], etching becomes too slow, therefore, this is also not suitable for practical use.

Table 1 shows the variation of the etching speed of ZnSe relative to the gas pressure, which pressures do not all full whithin the scope of the claimed invention, when the microwave inlet-power is 100W, the acceleration voltage is 500V, and pure chlorine gas is employed as etching gas.

P, R, and S in Table 1 represent gas pressure (Pa), etching speed (Å/min = 0.1 nm/min), and side etching condition, respectively.

Table 1

| P(Pa) | R (Å/min) | S (Side Etch) |
|---|---|---|
| $5 \times 10^{-3}$ | 100 | no |
| $1 \times 10^{-2}$ | 500 | no |
| $5 \times 10^{-2}$ | 650 | no |
| $1 \times 10^{-1}$ | 700 | no |
| $5 \times 10^{-1}$ | 800 | slightly |
| 1.0 | 1,000 | slightly |

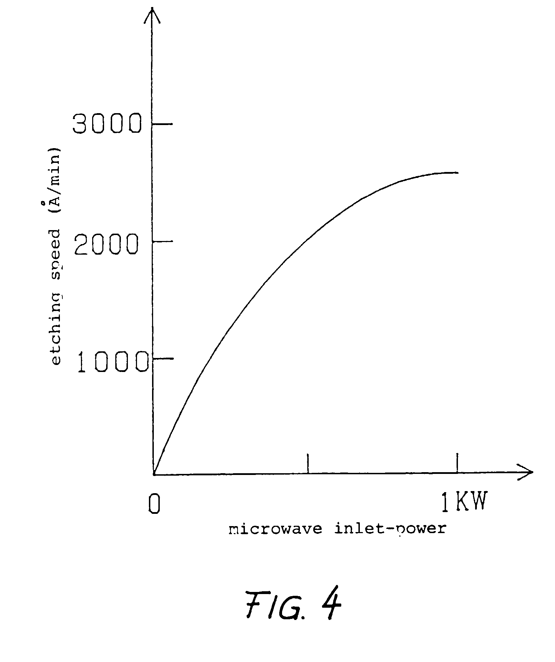

As shown in Fig. 4, the etching speed increases as the microwave inlet-power increases because the plasma density goes up when the microwave excitation becomes stronger. However, when the inlet-power is too high, the plasma temperature goes up causing electrodes to be deformed by heat, and temperature control becomes difficult because the substrate temperature goes up by emissive power. A good etching result was obtained in the range of 1 W - 1 kW.

Table 2 shows ZnSe etching speed dependency characteristics on microwave inlet-power when the etching gas is pure chlorine gas, the gas pressure is $1 \times 10^{-1}$ Pa, and the acceleration voltage is 400V. M and R in Table 2 represent microwave inlet-power (W) and etching speed (Å/min = 0.1 nm/min), respectively.

Table 2

| M(W) | R (Å/min) |
|---|---|
| 50 | 200 |
| 100 | 700 |
| 150 | 900 |
| 200 | 1,000 |
| 400 | 1,300 |
| 600 | 1,900 |
| 1,000 | 2,100 |

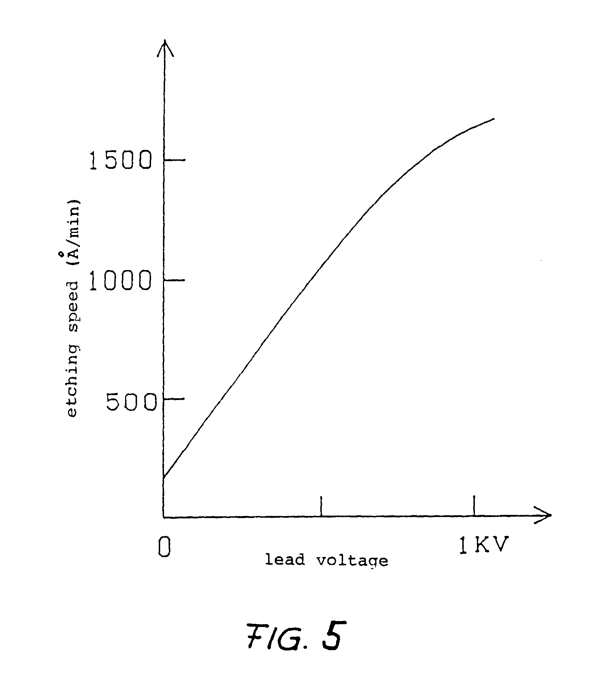

As shown in Fig. 5, the etching speed increases as the acceleration voltage increases. However, if the voltage is too high ($\geq$1 kV), physical sputtering becomes strong, thereby causing substantial damage to the substrate crystalline.

When acceleration voltage is 0V, and the substrate temperature is approximately 200°C, etching by radical species occurs. In this case etching progresses in all directions.

Table 3 shows the etching speed dependency characteristics on acceleration voltage when the etching gas is pure chlorine gas, the gas pressure is 1 x 10$^{-1}$ Pa, and the microwave inlet-power is 200W. H, R, and D in Table 3 represent acceleration voltage (V), etching speed ($\mathrm{Å/min} = 0.1$ nm/min), and damage condition on the substrate, respectively.

Table 3

| H(V) | R (Å/min) | D (Damage) |
|---|---|---|
| 200 | 500 | no |
| 300 | 700 | no |
| 400 | 850 | no |
| 500 | 1,000 | no |
| 600 | 1,200 | no |
| 700 | 1,300 | slightly |
| 800 | 1,500 | slightly |
| 1,000 | 1,600 | yes |

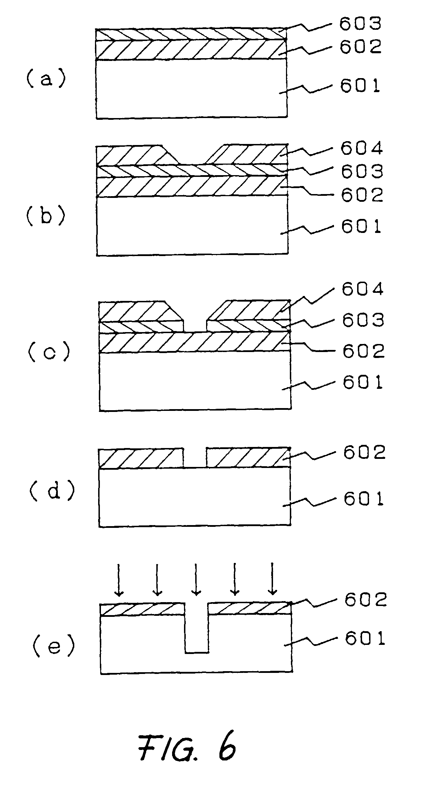

Fig. 6 illustrates another embodiment of this invention wherein vertical perpendicular etching of ZnSe was performed.

First, as shown in Fig. 6(a), a posi-type photoresist 602 was spin coated on ZnSe 601 and baked for 30 - 120 minutes at 200°C, and Ti 603 was formed by electron beam evaporation or the like to 100 nm (1,000Å) on photoresist 602.

As Fig. 6(b) shows, pattern forming of photoresist 604 was performed employing a regular photolithography process.

Then, as Fig. 6(c) shows etching of Ti 603 was performed employing photoresist 604 as a mask.

In wet etching, buffer hydrofluoric acid is employed, and in dry etching, reactive ion etching (RIE) employing $CF_4$ gas is employed. Dry etching, wherein side etching is minimal, is preferred for transforming a precise pattern.

As shown in Fig. 6(d), using Ti 603 as a mask, etching of photoresist 602 is performed by RIE employing oxygen plasma. Great attention must be paid to the oxygen gas pressure. In the case a regular dry etching apparatus with capacitively coupled parallel electrodes is employed for manufacturing an etching mask with a perpendicular sectional pattern without a taper shape, the preferred oxygen gas pressure is approximately 5 Pa. If the pressure is too high, etching progresses in all directions, which is not suitable in this case. Ti 603, which is used as an etching mask for etching photoresist 602, should be removed with buffer hydrofluoric acid or the like before etching of ZnSe.

When ZnSe etching is performed employing pure chlorine gas plasma under the same condition as the embodiment shown in Fig. 1, a vertical cross sectional pattern is formed as shown in Fig. 6(e). At this time, hardly any side etching occurs. Therefore, the method shown in Fig. 6 can be said to be effective as fas as anisotropy etching is concerned even though the process is complicated to some degree.

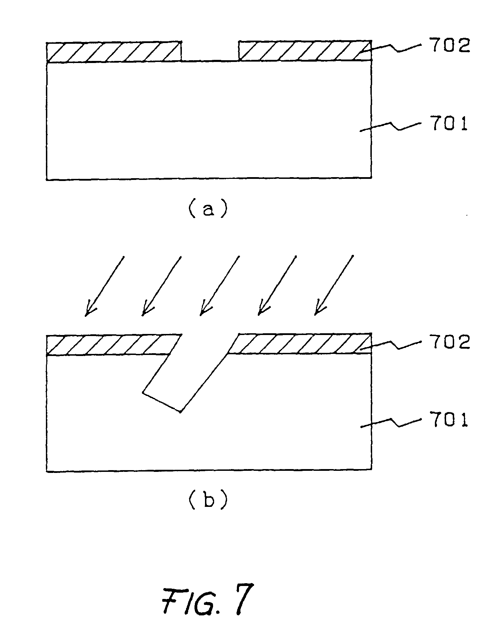

Fig. 7 shows an embodiment wherein etching was performed by directing an ion beam diagonally relative to the surface of a ZnSe substrate 701. Fig. 7(a) shows the condition before etching, and Fig. 7(b) shows a cross sectional view after etching by means of an ion beam directed in the direction of the arrows relative to the surface of the substrate. Etching progresses in the ion beam inlet direction first, resulting a diagonal groove formation.

ZnSe was employed to describe this embodiment. However, with other Zn $S_x$ Se$_{1-x}$ ($0<x\leq1$) compound semiconductors the embodiment is also effective.

Although a photoresist was employed according to the foregoing description, any mask material having a largely different etching rate compared to that of the materials to be etched can be used. For example, when ZnSe is to be etched, insulating materials, such as $SiO_x$, $SiN_x$, $Al_2O_3$, or the like are also effective. $SiO_x$, $SiN_x$ are possible for a precision process, therefore, they are suitable for etching mask materials.

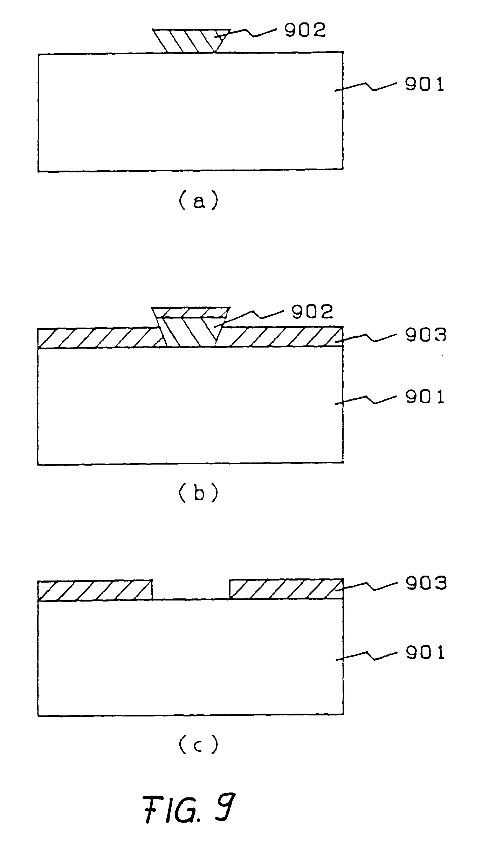

The case when $Al_2O_3$ was employed as a mask material is described hereinafter. $Al_2O_3$ was employed in this embodiment as etching mask 102 shown in Fig. 1(a). The mask was manufactured by liftoff as shown in Fig. 9(a) - Fig. 9(c). In other words, a posi-type photoresist 902 pattern was formed on ZnSe semiconductor layers 901 employing the regular photolithography as shown in Fig. 9(a). Then, $Al_2O_3$ 903, which was to be the mask material, was formed by electron beam evaporation or the like as shown in Fig. 9(b). $Al_2O_3$ on photoresist 902 could be removed in an organic solvent, such as acetone. As a result, an $Al_2O_3$ mask was formed on ZnSe as shown in Fig. 9(c).

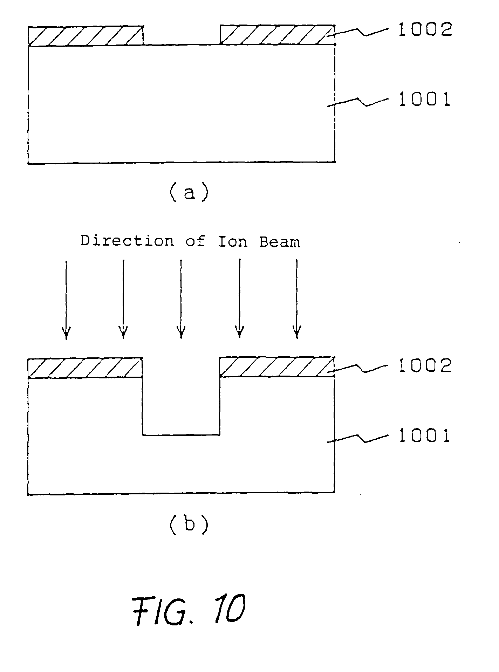

Fig. 10(b) is a cross sectional view of the etching result of a sample which was manufactured by the foregoing process. Etching was performed under the condition wherein 99.999% pure chlorine was used as reactive gas, the gas pressure was 1.0 x 10$^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 60 nm/min (600Å/min), and the etching speed of $Al_2O_3$ mask material was approximately 2 nm/min (20Å/min). On the other hand, the etching speed of a posi-type photoresist is, when baking condition is at 120°C for 30 minutes, approximately 20 nm/min (200Å/min), and approximately the same with $SiO_2$. The $Al_2O_3$ etching speed was approximately 0.03 times faster compared to ZnSe, and compared to photoresist and $SiO_2$, its selectivity is approximately 10 times larger, therefore, it is very effective as an etching mask for ZnSe. The cross sectional pattern after etching was almost perpendicular achieving etching with great anisotropy. The etching condition with this high selectivity (etching speed ratio relative to ZnSe is $\leq 0.1$) was achieved when the etching gas pressure was in the range of 5 x $10^{-3}$ Pa - 1 Pa and the acceleration voltage was $\leq 1$ kV. In the etching mechanism wherein physical sputtering dominates the etching condition, a large difference in etching rates cannot be obtained, however, a large difference in etching rates is achieved when chemical reaction etching by reactive ions dominates the etching condition. Etching was performed mainly by reactive ions in the above condition. As a result of the evaluation of the pollution condition of the ZnSe surface after etching employing Auger electron spectroscopy, compared to the case when a photoresist was employed as a mask, pollution by carbon decreased dramatically, thereby achieving a clean surface.

Nickel, molybdenum, or tungsten was employed in another embodiment as etching mask 1002 of the foregoing embodiment shown in Fig. 10(a). The mask was manufactured by liftoff which was the same as in the foregoing embodiment. Nickel was formed by electron beam evaporation and when molybdenum or tungsten was employed as a mask material, the film was formed by sputtering. Etching was performed under the condition wherein 99.999% pure chlorine was used as reactive gas, the gas pressure was 1.0 x $10^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 60 nm/min (600Å/min), and the etching speed of the nickel mask material was approximately 10 nm/min (100Å/min), of molybdenum, approximately 12 nm/min (120Å/min), and of tungsten, approximately 13 nm/min (130Å/min). On the other hand, the etching speed of a posi-type photoresist is, when baking condition is at 120°C for 30 minutes, approximately 20 nm/min (200Å/min), and approximately the same with $SiO_2$. The etching speed of nickel, molybdenum, or tungsten was approximately 0.17 - 0.22 times that of ZnSe, therefore, these materials have high selectivity, and they are very effective as an etching mask of ZnSe. The cross sectional pattern after etching was almost perpendicular achieving etching with great anisotropy. The etching condition with this high selectivity (etching speed ratio relative to ZnSe is $\leq 0.3$) was achieved when the etching gas pressure was in the range of 5 x $10^{-3}$ Pa - 1 Pa and the acceleration voltage was $\leq 1$ kV. In the etching mechanism wherein physical sputtering dominates the etching condition, a large difference in etching rates cannot be obtained, however, a large difference in etching rates is achieved when chemical reaction etching by reactive ions dominates the etching condition. Etching was performed mainly by reactive ions in the above condition. As a result of the evaluation of the pollution condition of the ZnSe surface after etching employing Auger electron spectroscopy, compared to the case when a photoresist was employed as a mask, pollution by carbon decreased dramatically, thereby achieving a clean surface.

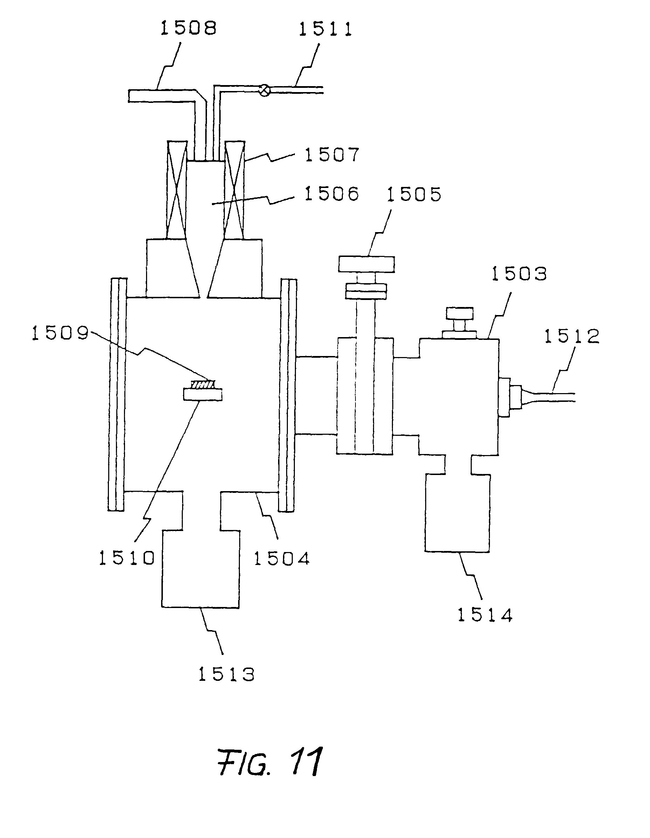

Next, another embodiment wherein dry etching employing radical species of a pure chlorine gas was performed, is described hereinafter. Fig. 11 shows a structural outline cross sectional view of an etching system employed in this embodiment. An ECR plasma generating chamber 1506 is evacuated differentially so that it keeps a lower vacuum than an etching chamber 1504, and radical species are irradiated to a sample 1509 in the etching chamber by thermal kinetic energy. In Fig. 11 1503 designates a sample preparation chamber, 1505 a gate valve, 1507 a magnetic coil, 1508 a microwave waveguide, 1510 a sample holder, 1511 a gas inlet, 1512 a transporting shaft and 1514 an evacuating system.

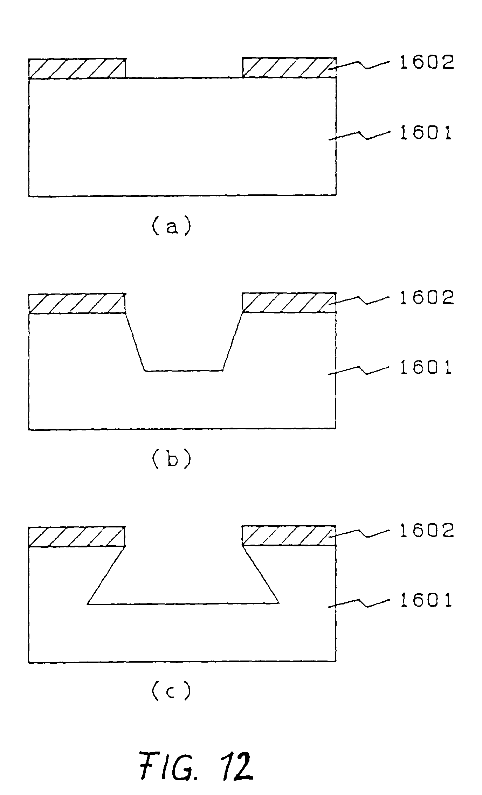

Fig. 12(a) shows a cross sectional view of ZnSe before etching. 1601 is ZnSe and 1602 is an etching mask. (001) is the direction of ZnSe surface. Etching mask 1602 is comprised of $SiO_2$. Etching was performed under the condition which does not full wihtin the scope of the invention wherein 99.999% pure chlorine gas was employed as reactive gas, the gas pressure was 1.0 x $10^{-1}$ Pa, the microwave inlet-power was 100W, and the sample temperature was 250°C. Fig. 12(b) and (c) show cross sectional views after etching, employing the system in Fig. 11. (b) is a cross sectional view from direction [$\bar{1}$10], and (c) is a cross sectional view from direction [110]. The etching speed of ZnSe was approximately 90 nm/min (900Å/min). Since there are no ions, as Figs. 12(b) and (c) show, the processed cross sectional pattern is dependent on the crystalline direction, which is the same as in the case of wet etching. There was no problem in connection with the etching speed for practical use. Further, the dispersion of the etching speed when the substrate was 20mm x 20mm was $\leq\pm5\%$, and the dispersion between batches was $\leq\pm7\%$.

Next, an embodiment wherein rinsing by a hydrogen ion beam was performed before the said etching, is described hereinafter. After putting the substrate in the sample holder, cleaning of the substrate surface by a hydrogen ion beam was performed when 99.9999% pure hydrogen was employed, the gas pressure was 1.0 x $10^{-1}$ Pa, the microwave inlet-power was 100W, the acceleration voltage was 400V, the sample temperature was 25°C, and the ion beam irradiation direction was perpendicular relative to the substrate. A substrate with a clean surface was obtained because remaining impurities were sputtered away by the hydrogen ion beam. Then etching was performed under the condition wherein 99.999% pure chlorine gas was employed as reactive gas, the gas pressure was 1.0 x $10^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 60 nm/min (600Å/min). The etching speed of a posi-type photoresist is, when the post bake condition is set at 120°C for 30 minutes, approximately 20 nm/min (200Å/min). Stability and reproducibility of the etching speed were improved because of the cleaning by a hydrogen ion beam before etching compared to the case when cleaning was not performed. The dispersion of the etching speed when the substrate was 20mm x 20mm was $\leq \pm 3\%$, and the surface morphology was almost the same as before the process. Also, the cleaning of the substrate surface by a hydrogen ion beam was effective in suppressing side etching.

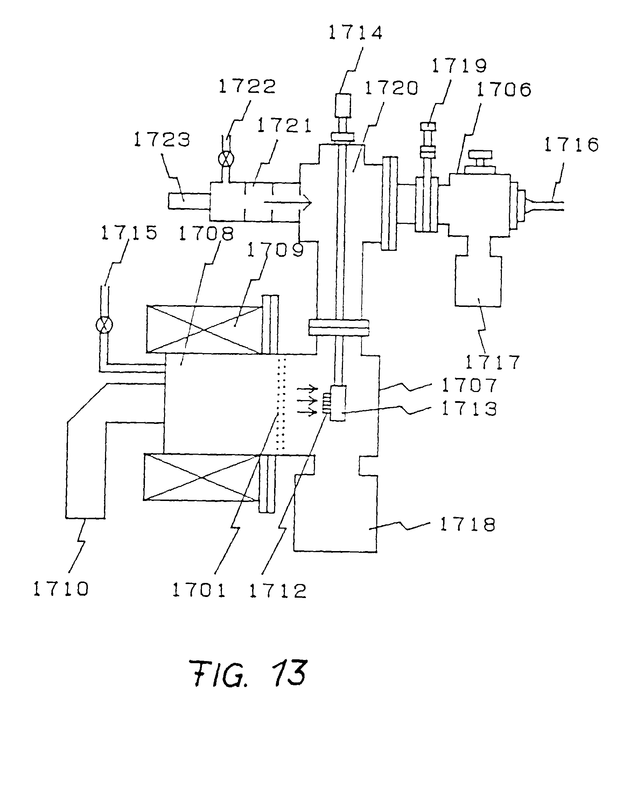

Next, an embodiment wherein a substrate was treated by hydrogen radicals before etching is described hereinafter. Fig. 13 shows a cross sectional view of a structural outline of an etching system employed in this embodiment. A microwave waveguide 1723 is connected to a plasma chamber 1721 which maintains hydrogen gas which is introduced through an inlet 1722 in plasma condition. Since plasma chamber 1721 is evacuated differentially from cleaning chamber 1720, hydrogen radicals, which are generated by plasma discharge, jet into cleaning chamber 1720 by thermal kinetic energy. Since plasma chamber 1721 does not have ion acceleration electrodes, hydrogen ions do not jet into the cleaning chamber, but only hydrogen radicals do. Sample holder 1713 is moved to cleaning chamber 1720.

The sample is cleaned with hydrogen radicals by resistance heating sample holder 1713. After putting the substrate into sample holder 1713, it was moved to cleaning chamber 1720. Cleaning of substrate surface by a hydrogen radical beam was performed when 99.9999% pure hydrogen gas was employed, the gas pressure was $1.0 \times 10^{-2}$ Pa, the microwave inlet-power was 100W, the sample temperature was 400°C, and the hydrogen radical beam irradiation direction was perpendicular relative to the substrate. A substrate with a clean surface was obtained because remaining impurities were etched away by the hydrogen radical beam. Then etching was performed under the condition wherein 99.999% pure chlorine gas was employed as reactive gas, the gas pressure was $1.0 \times 10^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 70 nm/min (700Å/min). The etching speed of a posi-type photoresist is, when the post bake condition is set at 120°C for 30 minutes, approximately 20 nm/min (200Å/min). Stability and reproducibility of the etching speed were improved because of the cleaning by a hydrogen radical beam before etching compared to the case when cleaning was not performed. The dispersion of the etching speed when the substrate was 20mm x

20mm was $\leq \pm 3\%$, and the surface morphology was almost the same as before the process. Elements 1701, 1706, 1707, 1708, 1709, 1710, 1712, 1714, 1715, 1716, 1717, 1718 and 1719 correspond to elements 806, 801, 802, 803, 804, 805, 807, 809, 810, 812 and 813, respectively, and are no further described here.

Next, treatment of the substrate by a rare gas ion beam before etching is described hereinafter. Cleaning of the substrate surface by a rare gas ion beam before etching was performed when 99.9999% pure argon gas was employed, the gas pressure was $1.0 \times 10^{-1}$ Pa, the microwave inlet-power was 100W, the acceleration voltage was 400V, the sample temperature was 25°C, and the argon ion beam irradiation direction was perpendicular relative to the substrate. A substrate with a clean surface was obtained because remaining impurities were sputtered away by the argon ion beam. Then, etching was performed under the condition wherein 99.999% pure chlorine gas was employed as reactive gas, the gas pressure was $1.0 \times 10^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 70 nm/min (700Å/min). The etching speed of a posi-type photoresist is, when the post bake condition is set at 120°C for 30 minutes, approximately 20 nm/min (200Å/min). Stability and reproducibility of the etching speed were improved because of the cleaning by an argon ion beam before etching compared to the case when cleaning was not performed. The dispersion of the etching speed when the substrate was 20mm x 20mm was $\leq \pm 3\%$, and the surface morphology was almost the same as before the process.

Next, an embodiment wherein a substrate was treated with an acidic solution before etching is described hereinafter. The cleaning with an acidic solution before dry etching was performed as follows:

After soaking the substrate in the solution of hydrochloric acid (35 weight %) and water, 1:1, for 15 seconds, water rinsing was performed. A very thin layer on the surface of the substrate was etched away by the acidic solution, thereby providing a clean surface of the substrate. After water rinsing, the substrate was moved in isopropyl alcohol, and nitrogen blow was performed. Then, the substrate was moved to a sample holder. Etching was performed under the condition wherein 99.999% pure chlorine gas was employed as reactive gas, the gas pressure was $1.0 \times 10^{-1}$ Pa, the microwave inlet-power was 100W, the acceleration voltage was 500V, the sample temperature was 25°C, and the ion beam irradiation direction was perpendicular relative to the substrate. The etching speed of ZnSe was approximately 70 nm/min (700Å/min). The etching speed of a posi-type photoresist is, when the post bake condition is set at 120°C for 30 minutes, approximately 20 nm/min (200Å/min). Stability and reproducibility of the etching speed was improved because of the cleaning with a solution of hydrochloric acid before etching compared to the case when cleaning was not performed. The dispersion of the etching speed when the substrate was 20mm x 20mm was $\leq \pm 3\%$, and the surface morphology was almost the same as before the process.

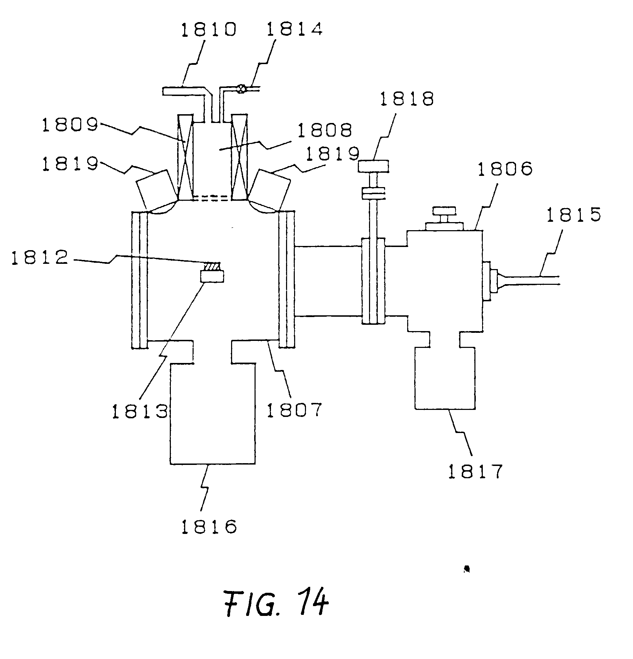

Next, an embodiment wherein light irradiation was performed at the same time of performing ion beam or radical beam irradiation is described hereinafter. Fig. 14 shows a cross sectional view of the structural outline of the etching system which was employed in this embodiment of the invention. 1819 is a mercury lamp, that is constructed to perform light irradiation on a sample and etching gas. Elements 1806, 1807, 1809, 1810, 1812, 1813, 1814, 1815, 1816, 1817 and 1818 in Fig. 14 correspond to elements 801, 803, 804, 805, 807, 808, 810, 811, 813, 812 and 809 in Fig. 8, respectively, and are no further described here. 1808 is an ECR plasma generating chamber.

Etching was performed under the condition wherein 99.999% pure chlorine gas was employed as reactive gas, the gas pressure was $1.0 \times 10^{-1}$ Pa, the microwave inlet-power was 100W, the acceleration voltage was 500V, the sample temperature was 25°C, the mercury lamp power was 200W, and the ion beam irradiation direction was perpendicular relative to the substrate. The etching speed of ZnSe was approximately 110 nm/min (1,100Å/min). The etching speed of a posi-type photoresist is, when the post bake condition is set at 120°C for 30 minutes, approximately 28 nm/min (280Å/min). Under the same condition wherein pure chlorine gas was employed, but light irradiation was not performed, the etching speed was 60 nm/min (600Å/min). By performing light irradiation the etching speed became twice as much. In other words, a low plasma density and low accelerating voltage are sufficient for the same amount of etching when light irradiation is performed, thus, decreasing damage to the semiconductor substrate.

Next, the effect of the substrate temperature at the time of etching is described hereinafter. The cooling/heating part and sample installing part are separated in a sample holder, but they are completely attached to each other. In the cooling/heating part, there are a water cooling tube and a heater to control the sample temperature. The temperature control range is -20°C - 400°C. An organic solvent, such as, methanol is employed for cooling $\leq 10$°C.

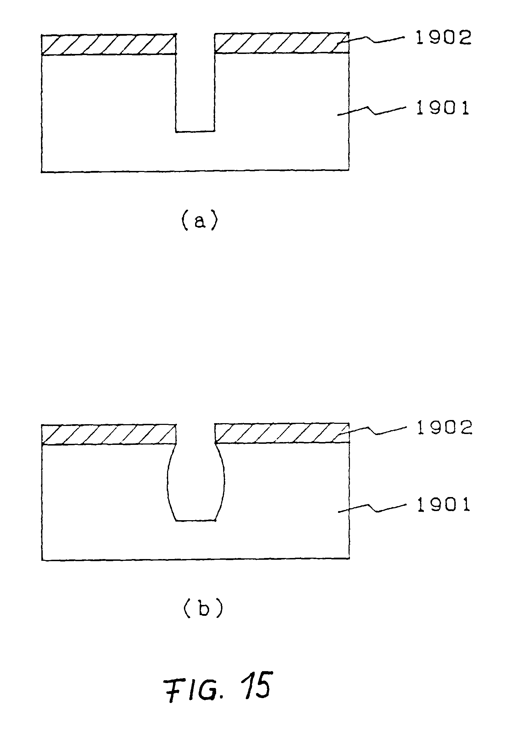

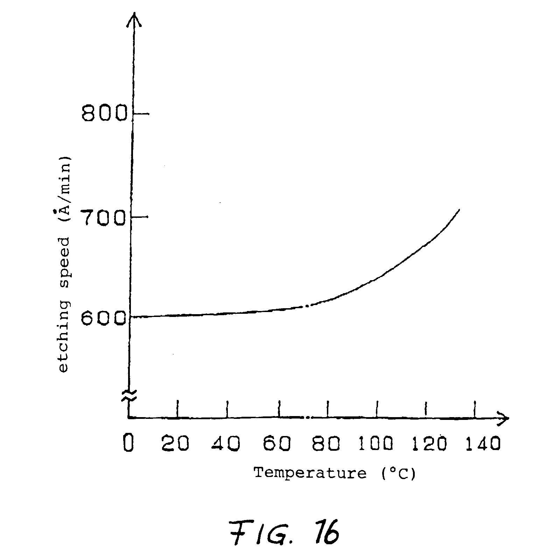

Etching was performed under the condition where 99.999% pure chlorine gas was employed as reactive gas, the gas pressure was $1.0 \times 10^{-1}$ Pa, the microwave inlet-power was 100W, the acceleration voltage was 500V, and the ion beam irradiation direction was perpendicular relative to the substrate. Fig. 15(a) shows the etching result when the substrate temperature was 25°C, and Fig. 15(b) shows the etching result when the substrate temperature was 120°C. The cross sectional shape when etching was performed at 25°C was perpendicular as Fig. 15(a) shows, but it was curved when etching was performed at 120°C as Fig. 15(b) shows. When the side wall morphology was observed with a scanning electronic microscope (SEM), a smooth surface with 50000 - 100000 magnification was observed at 25°C, but is was very rough at 120°C. The reason for this roughness is that chloride, such as, $ZnCl_x$, $SeCl_x$, or the like, which are produced during etching, protect the side wall from the ion beam which spreads on the surface. However, since these chlorides have high volatility, they evaporate at 120°C, thus providing no protection and causing side etching, rendering bad morphology. The temperature range in which these chlorides work well as protective film is $\leq 80$°C. They evaporate over 80°C. Fig. 16 shows the etching speed of ZnSe relative to the substrate temperature. The etching speed starts to rise around 80°C, and this agrees with the foregoing description. When the temperature is $\leq 0$°C, the etching speed slows down, and the substrate holder's temperature becomes much lower compared to the surrounding, therefore, chlorides do not easily attach to the sample, causing difficult sample handling later on.

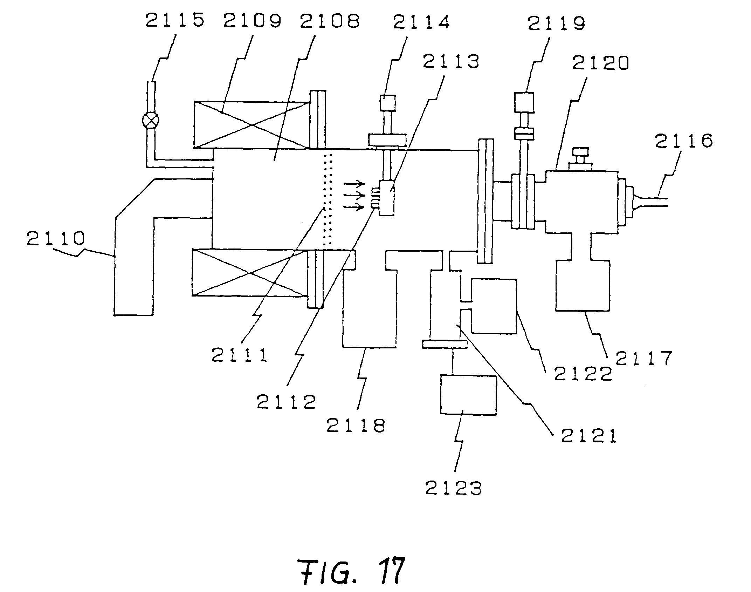

Next, an embodiment wherein an etching stop detection method was employed is described hereinafter. Fig. 17 shows a cross sectional view of the structural outline of the system which was employed in this embodiment of the invention. A differential evacuation apparatus 2122 with a gas analyzing tube 2121 is placed in etching chamber 2107, mass spectrum of gas, which is produced during etching, can be observed by mass spectrum analyzing equipment 2123. Elements 2108 to 2119 and 2120 in Fig. 17 correspond to elements 803 to 814 and 801, respectively, in Fig. 8 and are not further described here.

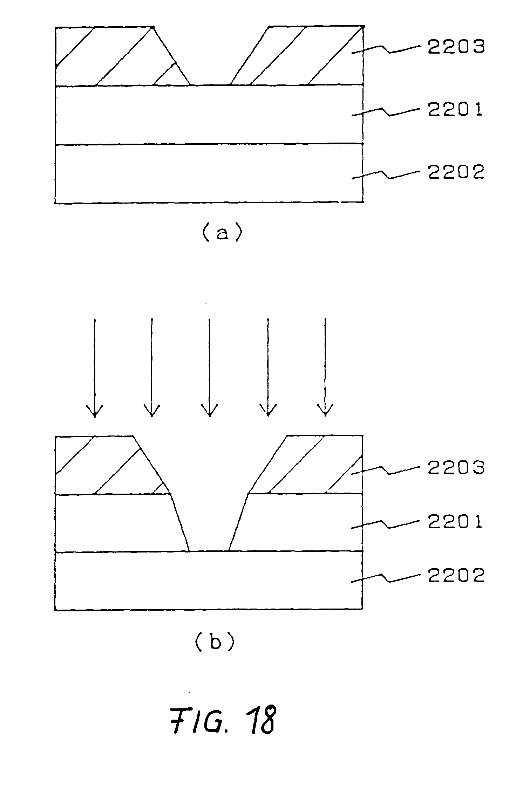

Fig. 18 shows a cross sectional view of ZnSe 2201 on GaAs 2202 after etching employing the system shown in Fig. 17. Fig. 18(a) shows a cross sectional view before etching. 2203 is a photoresist etching mask. A posi-type photoresist 2203 was employed, and the cross sectional pattern of the mask was taper because the mask was formed employing general photolithography. After the substrate was moved to the sample holder 2113, etching was performed under the condition wherein 99.999% pure chlorine gas was employed as reactive gas, the gas pressure was $1.0 \times 10^{-1}$ Pa, the microwave inlet-power was 100W, the acceleration voltage was 500V, the sample temperature was 25°C, and the ion beam irradiation direction was perpendicular relative to the substrate. The mass spectrum is observed during etching by the mass spectrum analyzing equipment 2123. Etching can be stopped at the interface of ZnSe 2201 and GaAs 2202 by stopping the microwaves when the peaks of Zn and Se in the mass spectrum start to decrease and the quantity spectrum of Ga and As starts to generate. Fig. 18(b) shows a cross sectional view after etching. The etching speed of ZnSe was approximately 60 nm/min (600Å/min). The etching speed of a posi-type photoresist is, when the post bake condition is set at 120°C for 30 minutes, approximately 20 nm/min (200Å/min). Since the shape of the etching mask is taper, and etching occurs on the etching surface also by sputtering, the processed cross sectional shape becomes as shown in Fig. 18(b), and a perpendicular cross section cannot be achieved even when the ion beam is irradiated perpendicularly. However, as far as the etching speed is concerned, there is no problem for practical use. The dispersion of the etching speed when the substrate was 20mm x 20mm was ≤±5%, and the surface morphology after the process was good. Since the etching progress was detected and stopped by means of mass spectroscopy, compared to the case when the etching depth was controlled by the etching time, there was no ZnSe residue and over etching of GaAs could be controlled to be minimal, thereby achieving etching with extreme precision and reproducibility.

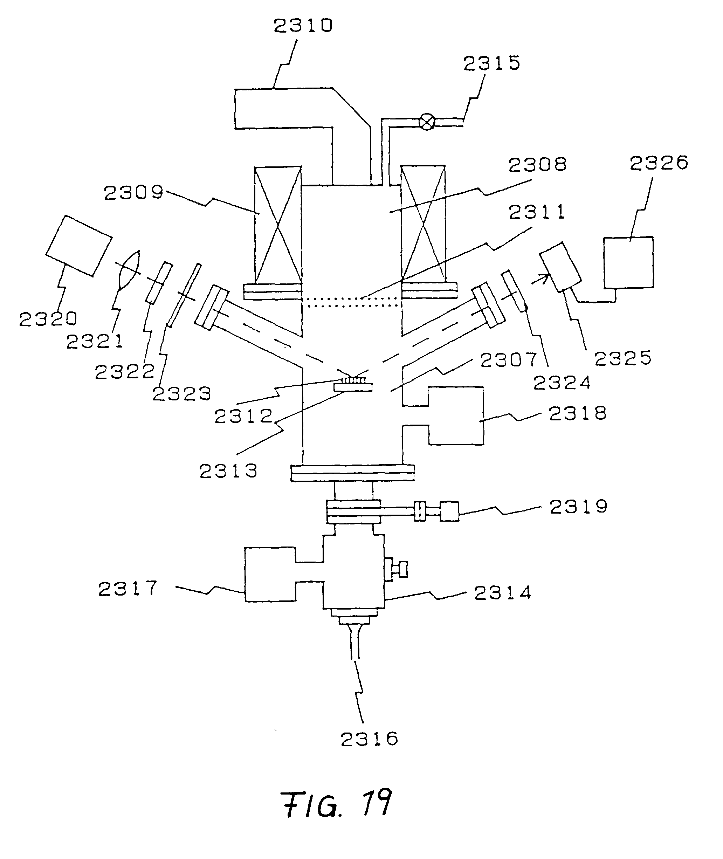

Fig. 19 shows a cross sectional view of the structural outline of a system which was employed in an embodiment of this invention. An etching chamber 2307 has a light inlet port and light outlet port for ellipsometry. Light is emitted from a light source 2320 at the inlet region and linearly polarized via a polarizer 2322, and further circularly polarized via a $\lambda/4$ plate 2323. The light becomes linearly polarized after being reflected by a sample 2312, and through the outlet port and via photodetector 2324 the light enters a photomultiplier tube 2325. The rotation angle of polarizer 2322 and photodetector 2324 and the information from photomultiplier tube 2325 are analyzed by a data analyzing device 2326 to obtain the refractive index and the film thickness.

The refractive index and the film thickness of the exposed part of ZnSe are continuously measured by ellipsometry during etching, and when it reaches the desired thickness, the microwave is stopped. Since the refractive index changes greatly when etching process reaches the interface of ZnSe and GaAs, etching can be stopped easily at this interface. Further, since the etching progress is detected and stopped by means of ellipsometry, compared to the case when the etching depth is controlled by the etching time, there is no over etching, thereby achieving etching with extreme precision and reproducibility. Elements 2308 to 2319 correspond to elements 803 to 808, 801 and 810 to 814 in Fig. 8, respectively. 2321 is a condensor lens.

The effects obtainable according to this invention are as follows:

By employing a reactive ion beam produced by microwave excitation and ECR plasma as an etching method of $Zn\,S_x\,Se_{1-x}$ ($0 \leq x \leq 1$) compound semiconductors, compared to the wet etching technique or dry etching, such as, ion etching or reactive ion etching of the prior art, etching with much superior reproducibility and controllability can be achieved. Especially, compared to the dry etching technique of the prior art, damage to semiconductor layers can be reduced dramatically. Also, by controlling the ion beam and the shape of the etching mask, a precision process for forming, such as, a groove with taper, a perpendicular cross section, or a diagonal groove becomes possible. Therefore, devices employing $Zn\,S_x\,Se_{1-x}$ ($0 \leq x \leq 1$) compound semiconductors can be easiliy manufactured with reproducibility and reliability. Further, since the etching rate can be controlled by choosing from various reactive gases and the stability of the plasma can be achieved, etching depth can be controlled with good reproducibility, thus providing an easy precision process for manufacturing various devices. Further, an extremely smooth etching side surface and the exact etching pattern as the mask pattern can be obtained. Also, etching can be performed under low pressure and the etching process can be detected. Therefore, regardless of the etching speed, the etching can be detected with precision and reproducibility. Thus reproducibility between batches in dry etching of II-VI group semiconductors increases dramatically, thereby rendering easy mass production of various devices possible.

## Claims

1.   A method of dry etching a $Zn\,S_x\,Se_{1-x}$ compound semiconductor substrate, wherein $0 \leq x \leq 1$, comprising the steps of:

   -   forming an etching mask on said $Zn\,S_x\,Se_{1-x}$ compound semiconductor substrate,
   -   dry etching the masked $Zn\,S_x\,Se_{1-x}$ compound semiconductor substrate in a microwave excitation ECR plasma chamber wherein a pure chlorine gas is activated at a pressure of 0.1 Pa to form a directional ion or radical etch beam which irradiates said masked $Zn\,S_x\,Se_{1-x}$ compound semiconductor substrate, and
   -   said masked $Zn\,S_x\,Se_{1-x}$ compound semiconductor substrate is kept at a temperature in the range of 0°C - 80°C during the dry etching.

2.   The method according to claim 1, wherein said etching mask is of an insulating material, such as a photoresist, silicon oxide, silicon nitride, or aluminum oxide.

3.   The method according to claim 1, wherein said etching mask is of a metal, such as molybdenum, nickel, or tungsten.

4.   The method according to any one of the preceding claims, wherein a hydrogen ion cleaning beam is irradiated onto said masked $Zn\,S_x\,Se_{1-x}$ compound semiconductor substrate before the dry etching of said masked $Zn\,S_x\,Se_{1-x}$ compound semiconductor substrate.

5.   The method according to any one of the preceding claims, wherein the surface of said masked $Zn\,S_x$

Se$_{1-x}$ compound semiconductor substrate is soaked by an acidic solution before the dry etching of said masked Zn S$_x$ Se$_{1-x}$ compound semiconductor substrate.

6. The method according to any one of the preceding claims, wherein the dry etching of said masked Zn S$_x$ Se$_{1-x}$ compound semiconductor substrate is carried out under light irradiation.

7. The method according to any one of the preceding claims, wherein the microwave excitation is with a microwave inlet-power in the range of 1 W - 1 kW.

8. The method according to any one of the preceding claims, wherein an acceleration voltage in the range of 0 V - 1 kV is applied which accelerates said directional ion etch beam from a discharge chamber to said masked Zn S$_x$ Se$_{1-x}$ compound semiconductor substrate during the dry etching.

9. The method according to any one of the preceding claims, wherein a measurement of the mass spectrum in the plasma chamber is performed during the dry etching of said masked Zn S$_x$ Se$_{1-x}$ compound semiconductor substrate.

10. The method according to any one of the preceding claims, wherein a measurement of the mass index and film thickness of said masked Zn S$_x$ Se$_{1-x}$ compound semiconductor substrate is performed by ellipsometry during said dry etching of said masked Zn S$_x$ Se$_{1-x}$ compound semiconductor substrate.

**Patentansprüche**

1. Verfahren zum Trockenätzen eines ZnS$_x$Se$_{1-x}$-Verbindungshalbleitersubstrats, wobei $0 \leq x \leq 1$, umfassend folgende Schritte:

   - Bilden einer Ätzmaske auf dem ZnS$_x$Se$_{1-x}$-Verbindungshalbleitersubstrat,
   - Trockenätzen des maskierten ZnS$_x$Se$_{1-x}$-Verbindungshalbleitersubstrats in einer Mikrowellenanregungs-ECR-Plasmakammer, in der reines Chlorgas bei einem Druck von 0,1 Pa aktiviert wird, um einen gerichteten Ionen- oder Radikalenätzstrahl zu bilden, der das maskierte ZnS$_x$Se$_{1-x}$-Verbindungshalbleitersubstrat bestrahlt, und
   - das maskierte ZnS$_x$Se$_{1-x}$-Verbindungshalbleitersubstrat wird während des Trockenätzens auf einer Temperatur im Bereich von 0°C bis 80°C gehalten.

2. Verfahren nach Anspruch 1, bei dem die Ätzmaske aus einem Isoliermaterial ist, wie beispielsweise einem Fotolack, Siliciumoxid, Siliciumnitrid oder Aluminiumoxid.

3. Verfahren nach Anspruch 1, bei dem die Ätzmaske aus einem Metall ist, wie beispielsweise Molybdän, Nickel oder Wolfram.

4. Verfahren nach einem der vorhergehenden Ansprüche, bei dem ein Wasserstoffionenreinigungsstrahl vor dem Trockenätzen des maskierten ZnS$_x$Se$_{1-x}$-Verbindungshalbleitersubstrats auf das maskierte ZnS$_x$Se$_{1-x}$-Verbindungshalbleitersubstrat gestrahlt wird.

5. Verfahren nach einem der vorhergehenden Ansprüche, bei dem die Oberfläche des maskierten ZnS$_x$Se$_{1-x}$-Verbindungshalbleitersubstrats vor dem Trockenätzen des maskierten ZnS$_x$Se$_{1-x}$-Verbindungshalbleitersubstrats einer sauren Lösung ausgesetzt wird.

6. Verfahren nach einem der vorhergehenden Ansprüche, bei dem das Trockenätzen des maskierten ZnS$_x$Se$_{1-x}$-Verbindungshalbleitersubstrats unter Lichtbestrahlung ausgeführt wird.

7. Verfahren nach einem der vorhergehenden Ansprüche, bei dem die Mikrowellenanregung mit einer Mikrowellen-Einspeiseleistung im Bereich von 1 W - 1 kW erfolgt.

8. Verfahren nach einem der vorhergehenden Ansprüche, bei dem eine Beschleunigungsspannung im Bereich von 0 V - 1 kV angelegt wird, die den gerichteten Ionenätzstrahl während des Trockenätzens von einer Entladungskammer zum maskierten ZnS$_x$Se$_{1-x}$-Verbindungshalbleitersubstrat beschleunigt.

9. Verfahren nach einem der vorhergehenden Ansprüche, bei dem eine Messung des Massenspektrums in der Plasmakammer während des Trockenätzens des maskierten ZnS$_x$Se$_{1-x}$-Verbindungshalbleitersubstrats ausgeführt wird.

10. Verfahren nach einem der vorhergehenden Ansprüche, bei dem eine Messung des Massenindexes und der Filmdicke des maskierten ZnS$_x$Se$_{1-x}$-Verbindungshalbleitersubstrats während des Trockenätzens des maskierten ZnS$_x$Se$_{1-x}$-Verbindungshalbleitersubstrats mittels Ellipsometrie ausgeführt wird.

**Revendications**

1. Procédé de gravure sèche d'un substrat semi-conducteur ZnS$_x$ Se$_{1-x}$ (où $0 \leq x \leq 1$), qui comprend les étapes consistant :

- à former un masque de gravure sur le substrat semi-conducteur à $ZnS_x Se_{1-x}$,
- à soumettre à une gravure sèche le substrat semi-conducteur à $ZnS_x Se_{1-x}$ masqué dans une chambre à plasma ECR à excitation par des micro-ondes, où du chlore gazeux pur est activé sous une pression de 0,1 Pa pour former un faisceau de gravure directionnel, par ions ou radicaux, qui est envoyé sur le substrat semi-conducteur à $ZnS_x Se_{1-x}$ masqué, et
- à maintenir le substrat semi-conducteur à $ZnS_x Se_{1-x}$ masqué à une température comprise entre 0 et 80°C pendant la gravure sèche.

2. Procédé selon la revendication 1, dans lequel le masque de gravure est en un matériau isolant tel qu'une photoréserve, l'oxyde de silicium, le nitrure de silicium ou l'oxyde d'aluminium.

3. Procédé selon la revendication 1, dans lequel le masque de gravure est en un métal tel que le molybdène, le nickel ou le tungstène.

4. Procédé selon l'une quelconque des revendications précédentes, dans lequel un faisceau de nettoyage à ions hydrogène est envoyé sur le substrat semi-conducteur à $ZnS_x Se_{1-x}$ masqué avant la gravure sèche du substrat semi-conducteur à $ZnS_x Se_{1-x}$ masqué.

5. Procédé selon l'une quelconque des revendications précédentes, dans lequel la surface du substrat semi-conducteur à $ZnS_x Se_{1-x}$ masqué est imprégnée d'une solution acide avant la gravure sèche du substrat semi-conducteur à $ZnS_x Se_{1-x}$ masqué.

6. Procédé selon l'une quelconque des revendications précédentes, dans lequel la gravure sèche du substrat semi-conducteur à $ZnS_x Se_{1-x}$ masqué est mise en oeuvre par exposition à de la lumière.

7. Procédé selon l'une quelconque des revendications précédentes, dans lequel l'excitation par des micro-ondes utilise une puissance d'entrée des micro-ondes comprise entre 1 W et 1 kW.

8. Procédé selon l'une quelconque des revendications précédentes, dans lequel on applique une tension d'accélération comprise entre 0 V et 1 kV, qui accélère le faisceau directionnel de gravure ionique, entre une chambre de décharge et le substrat semi-conducteur à $ZnS_x Se_{1-x}$ masqué pendant la gravure sèche.

9. Procédé selon l'une quelconque des revendications précédentes, dans lequel on procède à une mesure du spectre de masse dans la chambre à plasma pendant la gravure sèche du substrat semi-conducteur à $ZnS_x Se_{1-x}$ masqué.

10. Procédé selon l'une quelconque des revendications précédentes, dans lequel une mesure de l'indice de réfraction et de l'épaisseur du film du substrat semi-conducteur à $ZnS_x Se_{1-x}$ masqué est mise en oeuvre par ellipsométrie pendant la gravure sèche du substrat semi-conducteur à $ZnS_x Se_{1-x}$ masqué.

(a)

Direction of Ion Beam

(b)

FIG. 1

(a)

(b)

FIG. 2

FIG. 3

FIG. 4

FIG. 5

16

(a)

603
602
601

(b)

604
603
602
601

(c)

604
603
602
601

(d)

602
601

(e)

602
601

*FIG. 6*

(a)

(b)

FIG. 7

FIG. 8

902

901

(a)

902

903

901

(b)

903

901

(c)

FIG. 9

1002

1001

(a)

Direction of Ion Beam

1002

1001

(b)

FIG. 10

1508    1511

1507

1506    1505

1503

1509    1512

1510    1504

1514

1513

FIG. 11

(a)

(b)

(c)

*FIG. 12*

FIG. 13

FIG. 14

(a) figure:

1902

1901

(a)

(b) figure:

1902

1901

(b)

FIG. 15

FIG. 16

2115  2109  2108      2114        2119      2120

2113                                          2116

2110

2111

2112

2118        2122  2117

2121

2123

FIG. 17

(a)

(b)

FIG. 18

FIG. 19